# FASCICULE DE BREVET EUROPEEN

(11) **EP 3 332 273 B1**
(45) Date de publication et mention de la délivrance du brevet: **05.10.2022**
(21) Numéro de dépôt: 16760134.3
(22) Date de dépôt: 05.08.2016
(51) Int. Cl.: G02B 1/111, C23C 14/06, C23C 14/22, C03C 17/34

(54) **ARTICLE À PROPRIÉTÉS D'ADHÉRENCE OPTIMISÉES COMPORTANT UNE COUCHE DE NATURE SILICO-ORGANIQUE**
ARTIKEL MIT OPTIMIERTEN HAFTEIGENSCHAFTEN UND MIT EINER SCHICHT AUS ORGANISCHEM SILICIUM
ITEM HAVING OPTIMIZED ADHESIVE PROPERTIES AND COMPRISING A SILICON ORGANIC LAYER

(30) Priorité: 05.08.2015 FR 1557558
(43) Date de publication de la demande: 13.06.2018
(73) Titulaire: Essilor International, 94220 Charenton-Le-Pont (FR)
(72) Inventeur: CHIAROTTO, Sébastien, 94227 Charenton Le Pont Cedex (FR)
(74) Mandataire: Jacobacci Coralis Harle
(86) Numéro de dépôt international: PCT/FR2016/052041
(87) Numéro de publication internationale: WO 2017/021669

(56) Documents cités:
- EP-A1- 1 433 809
- WO-A1-2013/098531
- WO-A1-2014/199103

## Description

La présente invention concerne d'une manière générale un article, de préférence un article d'optique, notamment une lentille ophtalmique, possédant un revêtement interférentiel comportant au moins une couche de nature silico-organique, de préférence un revêtement antireflet, dont les propriétés d'adhérence ont été améliorées, ainsi qu'un procédé de préparation d'un tel article.

Il est connu de traiter les verres ophtalmiques, qu'ils soient minéraux ou organiques, de façon à empêcher la formation de reflets parasites gênants pour le porteur de la lentille et ses interlocuteurs. La lentille est alors pourvue d'un revêtement antireflet mono- ou multicouche, généralement en matière minérale, lequel présente dans le second cas une alternance de couches de haut indice de réfraction et de bas indice de réfraction.

Un revêtement réfléchissant réalise l'effet inverse, c'est-à-dire qu'il augmente la réflexion des rayons lumineux. Un tel type de revêtement est utilisé par exemple, pour obtenir un effet miroir dans des lentilles solaires.

Lors du taillage et du montage d'un verre chez l'opticien, le verre subit des déformations mécaniques qui peuvent provoquer des fissures dans les revêtements interférentiels réfléchissants ou antireflet minéraux, en particulier lorsque l'opération n'est pas conduite avec soin. De façon similaire, des sollicitations en température (chauffage de la monture) peuvent provoquer des fissures dans le revêtement interférentiel. Selon le nombre et la taille des fissures, celles-ci peuvent gêner la vue pour le porteur et empêcher la commercialisation du verre. En outre, pendant le port de verres organiques traités, des rayures peuvent apparaître. Dans les revêtements interférentiels minéraux, certaines rayures entraînent des fissurations, rendant les rayures plus visibles à cause d'une diffusion de lumière.

La demande EP 1324078 décrit une lentille revêtue d'un revêtement antireflet multicouche comprenant une alternance de couches de haut et de bas indice de réfraction dont la couche externe est une couche de bas indice de réfraction (1,42-1,48) consistant en une couche hybride, obtenue par co-évaporation sous vide et sous assistance ionique simultanément d'un composé organique (par exemple le polyéthylène glycol glycidyl éther, le polyéthylène glycol monoacrylate ou le N-(3-triméthoxysilylpropyl)gluconamide) et d'au moins un composé inorganique (silice ou silice et alumine).

Les brevets US 6,919,134 et US 7,318,959 décrivent un article d'optique comportant un revêtement antireflet comprenant au moins une couche dite "hybride" obtenue par co-évaporation d'un composé organique qui peut être un composé organosilicié tel qu'une huile de silicone modifiée, et d'un composé inorganique (SiO₂, SiO₂ + Al₂O₃, Nb₂O₅, Ta₂O₅, TiO₂, ZrO₂ ou Y₂O₃), qui lui confère une meilleure adhésion, une meilleure résistance thermique et une meilleure résistance à l'abrasion. La teneur en composé organique dans la couche hybride varie généralement de 0,02 % à 70 % en poids, de préférence de 0,5 % à 25 %. La couche hybride est généralement déposée par co-évaporation sous assistance ionique.

La demande EP 1433809 décrit un article d'optique comportant un revêtement antireflet déposé en phase vapeur comprenant au moins une couche dite "hybride" obtenue par évaporation d'un composé organique qui peut être un composé organosilicié et d'un composé inorganique (SiO₂, SiO₂ + Al₂O₃, Nb₂O₅, Ta₂O₅, TiO₂, ZrO₂ ou Y₂O₃). La teneur en composé organique dans la couche hybride varie généralement de 0,02 % à 25 % en poids. La couche hybride est généralement déposée par co-évaporation sous assistance d'un faisceau d'ions.

La demande WO 2013/098531, au nom du demandeur, décrit un article ayant des performances thermomécaniques améliorées, comprenant un substrat ayant au moins une surface principale revêtue d'un revêtement interférentiel multicouche, ledit revêtement comprenant une couche A non formée à partir de composés précurseurs inorganiques ayant un indice de réfraction inférieur ou égal à 1,55, qui constitue :
∘ soit la couche externe du revêtement interférentiel,
∘ soit une couche intermédiaire, directement en contact avec la couche externe du revêtement interférentiel, cette couche externe du revêtement interférentiel étant dans ce second cas une couche additionnelle ayant un indice de réfraction inférieur ou égal à 1,55, ladite couche A ayant été obtenue par dépôt, sous faisceau d'ions, d'espèces activées issues d'au moins un composé précurseur sous forme gazeuse de nature silico-organique tel que l'octaméthylcyclotétrasiloxane (OMCTS).

La demande WO 2014/199103, au nom du demandeur, décrit un revêtement interférentiel multicouche obtenu selon une technologie similaire, dont la couche externe est une couche A obtenue par dépôt, sous faisceau d'ions, d'espèces activées issues d'au moins un composé précurseur sous forme gazeuse de nature silico-organique tel que le 2,4,6,8-tétraméthylcyclotétrasiloxane (TMCTS).

Ces deux dernières demandes montrent qu'il est possible de faire adhérer une couche formée par dépôt d'un composé organosilicié sous vide et sous assistance ionique sur une couche inorganique de haut indice de réfraction.

En revanche, un dépôt de ces deux couches dans l'ordre inverse est problématique. Les inventeurs ont en effet constaté qu'il était difficile d'obtenir l'adhésion d'une couche inorganique de haut indice de réfraction lorsque celle-ci est déposée directement sur une couche de bas indice de réfraction formée par dépôt d'un composé organosilicié sous vide et sous assistance ionique. La partie expérimentale donne l'exemple d'un défaut d'adhésion observé à l'interface d'une couche de ZrO₂ déposée directement sur une couche de bas indice de réfraction à base de composé organosilicié, entrainant d'importantes craquelures sur toute la surface du verre.

Un objectif de l'invention est l'obtention d'un revêtement interférentiel, en particulier antireflet, permettant d'intégrer une ou plusieurs couches à base de composés organosiliciés à l'intérieur d'un revêtement interférentiel en vue d'obtenir des propriétés thermomécaniques améliorées, tout en conservant de bonnes performances optiques, en particulier un indice de réfraction élevé, et en résolvant le problème d'adhérence mentionné ci-dessus.

L'invention vise en particulier des articles possédant une température critique améliorée, c'est à dire, présentant une bonne résistance à la craquelure lorsqu'ils sont soumis à une élévation de température et/ou une bonne résistance à la craquelure lorsqu'ils sont soumis à déformation et/ou une bonne résistance à l'abrasion. Un autre objectif de l'invention est de disposer d'un procédé de fabrication d'un article équipé d'un revêtement interférentiel qui soit simple, facile à mettre en œuvre et reproductible.

Les inventeurs ont mis au point deux moyens de résoudre le problème posé tout en remplissant les objectifs fixés, l'un reposant sur une modification de la nature du matériau de la couche de haut indice de réfraction, remplacée par une couche obtenue par dépôt sous assistance d'une source d'ions, d'espèces activées, obtenues à partir d'un matériau précurseur de nature organique et d'un matériau précurseur de nature inorganique, l'autre reposant sur l'insertion d'une couche permettant l'adhésion entre la couche de haut indice de réfraction et la couche de bas indice de réfraction à base de composés organosiliciés.

Les buts fixés sont donc atteints selon l'invention par un article comprenant un substrat ayant au moins une surface principale revêtue d'un revêtement interférentiel comprenant, dans le sens de l'éloignement du substrat :
- une couche A obtenue par dépôt sous vide, assisté par une source d'ions, d'au moins un composé A organosilicié, ladite couche A présentant un indice de réfraction inférieur ou égal à 1,65 et contenant plus de 70 % en masse de composés A organosiliciés par rapport à la masse de la couche A, et en contact direct avec cette couche A,
- soit une couche B obtenue par dépôt sous vide, assisté par une source d'ions, d'au moins un oxyde métallique et d'au moins un composé B organosilicié, ladite couche B présentant un indice de réfraction supérieur à 1,65 et contenant au moins un oxyde métallique ayant un indice de réfraction supérieur ou égal à 1,8,
- soit une couche C comprenant un oxyde de silicium et ayant une épaisseur inférieure ou égale à 15 nm, en contact direct avec une couche E comprenant au moins un oxyde métallique ayant un indice de réfraction supérieur ou égal à 1,8.

Dans la présente demande, lorsqu'un article comprend un ou plusieurs revêtements à sa surface, l'expression "déposer une couche ou un revêtement sur l'article" signifie qu'une couche ou un revêtement est déposé sur la surface à découvert (exposée) du revêtement externe de l'article, c'est-à-dire son revêtement le plus éloigné du substrat.

Un revêtement qui est "sur" un substrat ou qui a été déposé "sur" un substrat est défini comme un revêtement qui (i) est positionné au-dessus du substrat, (ii) n'est pas nécessairement en contact avec le substrat (bien que préférentiellement, il le soit), c'est-à-dire qu'un ou plusieurs revêtements intermédiaires peuvent être disposés entre le substrat et le revêtement en question, et (iii) ne recouvre pas nécessairement le substrat complètement (bien que préférentiellement, il le recouvre). Lorsque "une couche 1 est localisée sous une couche 2", on comprendra que la couche 2 est plus éloignée du substrat que la couche 1.

L'article préparé selon l'invention comprend un substrat, de préférence transparent, ayant des faces principales avant et arrière, l'une au moins desdites faces principales comportant un revêtement interférentiel comprenant au moins une couche A, de préférence les deux faces principales. Une couche A est définie comme étant une couche obtenue par dépôt sous vide, assisté par une source d'ions, d'au moins un composé A organosilicié, ladite couche A présentant un indice de réfraction inférieur ou égal à 1,65,

Par face arrière (généralement concave) du substrat, on entend la face qui, lors de l'utilisation de l'article, est la plus proche de l'œil du porteur. Inversement, par face avant (généralement convexe) du substrat, on entend la face qui, lors de l'utilisation de l'article, est la plus éloignée de l'œil du porteur.

Bien que l'article selon l'invention puisse être un article quelconque, tel qu'un écran, un vitrage, des lunettes de protection utilisables notamment en environnement de travail, un miroir, ou un article utilisé en électronique, il constitue de préférence un article d'optique, notamment un filtre optique, mieux une lentille optique, et encore mieux une lentille ophtalmique, pour lunettes, ou une ébauche de lentille optique ou ophtalmique telle qu'une lentille optique semi-finie, en particulier un verre de lunettes. La lentille peut être une lentille polarisée, colorée, une lentille photochrome ou électrochrome.

Le revêtement interférentiel selon l'invention peut être formé sur au moins l'une des faces principales d'un substrat nu, c'est-à-dire non revêtu, ou sur au moins l'une des faces principales d'un substrat déjà revêtu d'un ou plusieurs revêtements fonctionnels.

Le substrat de l'article selon l'invention est de préférence un verre organique, par exemple en matière plastique thermoplastique ou thermodurcissable. Ce substrat peut être choisi parmi les substrats cités dans la demande WO 2008/062142, par exemple un substrat obtenu par (co)polymérisation du bis allyl carbonate du diéthylèneglycol, un substrat en poly(thio)uréthane ou à base de polyépisulfure, un substrat en polycarbonate de bis(phénol A) (thermoplastique), noté PC, ou un substrat en PMMA (polyméthacrylate de méthyle).

Avant le dépôt du revêtement interférentiel sur le substrat éventuellement revêtu, par exemple d'un revêtement anti-abrasion et/ou anti-rayure, il est courant de soumettre la surface dudit substrat, éventuellement revêtue, à un traitement d'activation physique ou chimique, destiné à augmenter l'adhésion de ce revêtement. Ce prétraitement est généralement conduit sous vide. Il peut s'agir d'un bombardement avec des espèces énergétiques et/ou réactives, par exemple un faisceau d'ions ("Ion Pre-Cleaning" ou "IPC") ou un faisceau d'électrons, d'un traitement par décharge corona, par effluvage, d'un traitement UV, ou d'un traitement par plasma sous vide. Il peut également s'agir d'un traitement de surface acide ou basique et/ou par solvants (eau ou solvant organique). Ces traitements sont décrits plus en détail dans la demande WO 2014/199103.

L'article selon l'invention est décrit dans la revendication 1 et comporte un revêtement interférentiel comprenant au moins une couche A, qui constitue une couche de bas indice de réfraction du revêtement interférentiel multicouche, notamment antireflet.

Selon le premier mode de réalisation de l'invention, le revêtement interférentiel selon l'invention comporte au moins une couche B, déposée sur la couche A et en contact direct avec elle, qui constitue une couche de haut indice de réfraction du revêtement interférentiel. Une couche B est définie comme étant une couche obtenue par dépôt sous vide, assisté par une source d'ions, d'au moins un oxyde métallique et d'au moins un composé B organosilicié, ladite couche B présentant un indice de réfraction supérieur à 1,65 et contenant au moins un oxyde métallique ayant un indice de réfraction supérieur ou égal à 1,8.

Selon le second mode de réalisation de l'invention, le revêtement interférentiel selon l'invention comporte au moins une couche C, déposée sur la couche A et en contact direct avec elle, qui constitue une couche de bas indice de réfraction du revêtement interférentiel. Une couche C est définie comme étant une couche comprenant un oxyde de silicium et ayant une épaisseur inférieure ou égale à 15 nm.

Selon le premier mode de réalisation de l'invention, le problème de la faible adhérence d'une couche de haut indice de réfraction à base d'un oxyde métallique déposée directement sur une couche A selon l'invention est résolu en modifiant la nature de ladite couche de haut indice de réfraction, c'est-à-dire en utilisant une couche B obtenue à partir du même précurseur oxyde métallique et d'un précurseur additionnel, un composé organosilicié. Une telle couche B présente une très bonne adhérence à la couche A, ce qui peut être mis en évidence par le test nommé nx10 coups, décrit en partie expérimentale. Ce matériau de la couche B remplace avantageusement les matériaux de haut indice de réfraction traditionnels tels que le dioxyde de titane ou de zirconium dans les revêtements interférentiels.

Les couches A et B selon l'invention constituent des couches de nature silico-inorganique du fait de l'utilisation d'un composé organosilicié lors de leur préparation, dans la mesure où le procédé de dépôt est tel que les couches déposées comprennent des atomes de carbone et de silicium.

Le revêtement interférentiel de l'invention est formé de préférence sur un revêtement anti-abrasion. Les revêtements anti-abrasion préférés sont des revêtements à base d'hydrolysats d'époxysilane comportant au moins deux groupements hydrolysables, de préférence au moins trois, liés à l'atome de silicium. Les groupements hydrolysables préférés sont des groupements alcoxysilane.

Le revêtement interférentiel peut être tout revêtement interférentiel classiquement utilisé dans le domaine de l'optique, en particulier de l'optique ophtalmique, excepté le fait qu'il comporte au moins une couche A selon l'invention. Le revêtement interférentiel peut être, sans limitation, un revêtement antireflet, un revêtement réfléchissant (miroir), de préférence un revêtement antireflet.

Un revêtement antireflet se définit comme un revêtement, déposé à la surface d'un article, qui améliore les propriétés anti-réfléchissantes de l'article final. Il permet de réduire la réflexion de la lumière à l'interface article-air sur une portion relativement large du spectre visible.

Comme cela est bien connu, les revêtements interférentiels, de préférence les revêtements antireflet, comprennent classiquement un empilement de matériaux diélectriques formant des couches de haut indice de réfraction (HI) et des couches de bas indice de réfraction (BI).

Dans la présente demande, une couche du revêtement interférentiel est dite couche de haut indice de réfraction lorsque son indice de réfraction est supérieur à 1,65, de préférence supérieur ou égal à 1,7, mieux supérieur ou égal à 1,8 et encore mieux supérieur ou égal à 2,0. Une couche d'un revêtement interférentiel est dite couche de bas indice de réfraction lorsque son indice de réfraction est inférieur ou égal à 1,65, de préférence inférieur ou égal à 1,55, mieux inférieur ou égal à 1,50 et encore mieux inférieur ou égal à 1,45.

Les couches HI sont des couches de haut indice de réfraction classiques, bien connues dans la technique. Elles comprennent généralement un ou plusieurs oxydes minéraux tels que, sans limitation, la zircone (ZrO₂), le dioxyde de titane (TiO₂), le pentoxyde de tantale (Ta₂O₅), l'oxyde de néodyme (Nd₂O₅), l'oxyde d'hafnium (HfO₂), l'oxyde de praséodyme (Pr₂O₃), le titanate de praséodyme (PrTiO₃), La₂O₃, Nb₂O₅, Y₂O₃, l'oxyde d'indium In₂O₃, ou l'oxyde d'étain SnO₂. Les matériaux préférés sont TiO₂, Ta₂O₅, PrTiO₃, ZrO₂, SnO₂, In₂O₃ et leurs mélanges.

Les couches BI sont également bien connues et peuvent comprendre, sans limitation, SiO₂, MgF₂, ZrF₄, de l'alumine (Al₂O₃) en faible proportion, AlF₃, et leurs mélanges, de préférence SiO₂. On peut également utiliser des couches SiOF (SiO₂ dopée au fluor). Idéalement, le revêtement interférentiel de l'invention ne comprend aucune couche comprenant un mélange de silice et d'alumine.

Préférentiellement, l'épaisseur totale du revêtement interférentiel est inférieure à 2 micromètres, mieux inférieure ou égale à 1,5 µm et mieux encore inférieure ou égale à 1 µm. L'épaisseur totale du revêtement interférentiel est généralement supérieure ou égale à 100 nm, de préférence supérieure ou égale à 200 nm et mieux supérieure ou égale respectivement à chacune des valeurs suivantes : 300 nm, 400 nm, 500 nm.

De préférence encore, le revêtement interférentiel, qui est de préférence un revêtement antireflet, comprend au moins deux couches de bas indice de réfraction (BI) et au moins deux couches de haut indice de réfraction (HI). Préférentiellement, le nombre total de couches du revêtement interférentiel est inférieur ou égal à 8, mieux inférieur ou égal à 6.

Dans un autre mode de réalisation, le revêtement interférentiel comprend plus de 8 couches.

Une couche du revêtement interférentiel est définie comme ayant une épaisseur d'au moins 1 nm. Ainsi, toute couche ayant une épaisseur de moins de 1 nm ne sera pas considérée lors du comptage du nombre de couches du revêtement interférentiel. Il n'est pas nécessaire que les couches HI et BI soient alternées dans le revêtement interférentiel, bien qu'elles puissent l'être selon un mode de réalisation de l'invention. Deux couches HI (ou plus) peuvent être déposées l'une sur l'autre, tout comme deux couches BI (ou plus) peuvent être déposées l'une sur l'autre.

Selon un mode de réalisation, toutes les couches de bas indice de réfraction du revêtement interférentiel sont des couches A, identiques ou différentes. Dans un autre mode de réalisation, la couche externe du revêtement interférentiel multicouche, c'est-à-dire la couche du revêtement interférentiel la plus éloignée du substrat dans l'ordre d'empilement, est une couche A selon l'invention. Une couche A selon l'invention est de préférence directement déposée sur une couche de haut indice de réfraction.

Dans un mode de réalisation, la couche externe du revêtement interférentiel est une couche de bas indice de réfraction qui se trouve préférentiellement directement en contact avec une couche sous-jacente de haut indice de réfraction. Selon un autre mode de réalisation, toutes les couches de haut indice de réfraction du revêtement interférentiel sont des couches B, identiques ou différentes. Dans certains articles selon l'invention, la première couche du revêtement interférentiel, dans l'ordre de dépôt, est une couche B selon l'invention, qui est de préférence déposée sur un revêtement anti-abrasion et/ou anti-rayure.

Selon un mode de réalisation préféré, le revêtement interférentiel est composé d'une alternance de couches A et B selon l'invention en contact direct les unes avec les autres.

Selon un autre mode de réalisation, toutes les couches du revêtement interférentiel comprennent au moins un composé organosilicié qui peut être choisi parmi les composés organosiliciés décrits plus bas.

Selon un mode de réalisation de l'invention, le revêtement interférentiel comprend une sous-couche. Elle constitue dans ce cas généralement la première couche de ce revêtement interférentiel dans l'ordre de dépôt des couches, c'est-à-dire la couche du revêtement interférentiel qui est au contact du revêtement sous-jacent (qui est généralement un revêtement anti-abrasion et/ou anti-rayures) ou du substrat, lorsque le revêtement interférentiel est directement déposé sur le substrat.

Par sous-couche du revêtement interférentiel, on entend un revêtement d'épaisseur relativement importante, utilisé dans le but d'améliorer la résistance à l'abrasion et/ou aux rayures dudit revêtement et/ou de promouvoir son adhésion au substrat ou au revêtement sous-jacent. La sous-couche selon l'invention peut être choisie parmi les sous-couches décrites dans la demande WO 2010/109154. La sous-couche peut également être une couche A ou comprendre une couche A.

Préférentiellement, la sous-couche a une épaisseur de 100 à 500 nm. Elle est préférentiellement de nature exclusivement minérale/inorganique et est préférentiellement constituée de silice SiO₂.

L'article de l'invention peut être rendu antistatique grâce à l'incorporation, de préférence dans le revêtement interférentiel, d'au moins une couche électriquement conductrice. La nature et la localisation dans l'empilement de la couche électriquement conductrice pouvant être utilisée dans l'invention sont décrites plus en détail dans la demande WO 2013/098531. Il s'agit de préférence d'une couche de 1 à 20 nm d'épaisseur comprenant de préférence au moins un oxyde métallique choisi parmi l'oxyde d'étain-indium (In₂O₃:Sn, oxyde d'indium dopé à l'étain noté ITO), l'oxyde d'indium (In₂O₃), et l'oxyde d'étain (SnO₂).

Les différentes couches du revêtement interférentiel (dont fait partie la couche antistatique optionnelle) sont préférentiellement déposées par dépôt sous vide selon l'une des techniques suivantes : i) par évaporation, éventuellement assistée par faisceau ionique ; ii) par pulvérisation par faisceau d'ion ; iii) par pulvérisation cathodique ; iv) par dépôt chimique en phase vapeur assisté par plasma. Ces différentes techniques sont décrites dans les ouvrages "Thin Film Processes" and "Thin Film Processes II," Vossen & Kern, Ed., Academic Press, 1978 et 1991 respectivement. Une technique particulièrement recommandée est la technique d'évaporation sous vide. De préférence, le dépôt de chacune des couches du revêtement interférentiel est réalisé par évaporation sous vide.

La couche B est formée d'un matériau obtenu par dépôt sous vide et sous l'assistance d'une source d'ions (notamment un faisceau d'ions), préférentiellement sous bombardement ionique, de deux catégories de précurseurs sous forme gazeuse, notamment par co-évaporation : au moins un oxyde métallique et au moins un composé B organosilicié. Cette technique de dépôt sous faisceau d'ions permet d'obtenir des espèces activées issues d'au moins un composé B organosilicié et d'au moins un oxyde métallique, sous forme gazeuse.

Dans la présente demande, les oxydes de métalloïdes sont considérés comme étant des oxydes métalliques, et le terme générique "métal" désigne également les métalloïdes.

La couche A est formée d'un matériau obtenu par dépôt sous vide et sous l'assistance d'une source d'ions (notamment un faisceau d'ions), préférentiellement sous bombardement ionique, selon le cas, d'une ou deux catégories de précurseurs sous forme gazeuse, notamment par évaporation ou co-évaporation : au moins un composé A organosilicié et optionnellement au moins un composé inorganique, qui est préférentiellement un oxyde métallique. La description qui suit fera généralement référence à l'oxyde métallique précurseur de la couche A mais sera également applicable au cas où le composé inorganique précurseur n'est pas un oxyde métallique. Cette technique de dépôt sous faisceau d'ions permet d'obtenir des espèces activées issues d'au moins un composé A organosilicié sous forme gazeuse.

De préférence, le dépôt des couches A et B est effectué dans une enceinte à vide, comportant un canon à ions dirigé vers les substrats à revêtir, qui émet vers ceux-ci un faisceau d'ions positifs générés dans un plasma au sein du canon à ions. Préférentiellement les ions issus du canon à ions sont des particules constituées d'atomes de gaz dont on a extrait un ou plusieurs électron(s), et formés à partir d'un gaz rare, d'oxygène ou d'un mélange de deux ou plus de ces gaz.

Des précurseurs, le composé B silico-organique et l'oxyde métallique (dans le cas de la couche B) ou le composé A silico-organique et les composés inorganiques optionnels (dans le cas de la couche A), sont introduits ou passent dans un état gazeux dans l'enceinte à vide. Ils sont de préférence amenés en direction du faisceau d'ions et sont activés sous l'effet du canon à ions.

Sans vouloir être limités par une quelconque théorie, les inventeurs pensent que dans le cas de la couche B, le canon à ions induit une activation/dissociation du composé précurseur B et de l'oxyde métallique précurseur, ce qui formerait des liaisons M-O-Si-CHₓ, M désignant l'atome de métal de l'oxyde métallique.

Cette technique de dépôt utilisant un canon à ions et un précurseur gazeux, parfois désignée par « ion beam déposition » est décrite notamment avec des seuls précurseurs organiques dans le brevet US 5508368.

Selon l'invention, de façon préférentielle, le seul endroit de l'enceinte où un plasma est généré est le canon à ions.

Les ions peuvent faire l'objet, le cas échéant, d'une neutralisation avant la sortie du canon à ions. Dans ce cas, le bombardement sera toujours considéré comme ionique. Le bombardement ionique provoque un réarrangement atomique et une densification dans la couche en cours de dépôt, ce qui permet de la tasser pendant qu'elle est en train d'être formée et présente l'avantage d'augmenter son indice de réfraction du fait de sa densification.

Lors de la mise en oeuvre du procédé selon l'invention, la surface à traiter est préférentiellement bombardée par des ions, d'une densité de courant généralement comprise entre 20 et 1000 µA/cm², préférentiellement entre 30 et 500 µA/cm², mieux entre 30 et 200 µA/cm² sur la surface activée et généralement sous une pression résiduelle dans l'enceinte à vide pouvant varier de 6.10⁻⁵ mbar à 2.10⁻⁴ mbar, préférentiellement de 8.10⁻⁵ mbar à 2.10⁻⁴ mbar. On utilise de préférence un faisceau d'ions argon et/ou oxygène. Lorsqu'un mélange d'argon et d'oxygène est employé, le ratio molaire Ar / O₂ est de préférence ≤ 1, mieux ≤ 0,75 et encore mieux ≤ 0,5. Ce ratio peut être contrôlé en ajustant les débits de gaz dans le canon à ions. Le débit d'argon varie généralement de 0 à 30 sccm. De préférence, aucun gaz rare n'est utilisé. Le débit d'oxygène O₂ varie de préférence de 5 à 60 sccm, mieux 5 à 40 sccm et encore mieux de 5 à 30 sccm, et est d'autant plus grand que le débit des composés précurseurs des couches A et B est élevé.

En ce qui concerne la couche B, le débit d'oxygène est de préférence supérieur ou égal à 20 sccm durant la co-évaporation, afin d'obtenir une meilleure adhérence d'une telle couche sur une couche A sous-jacente.

Les ions du faisceau d'ions, préférentiellement issus d'un canon à ions, utilisés au cours du dépôt de la couche A et/ou B ont de préférence une énergie allant de 5 à 1000 eV, mieux de 5 à 500 eV, préférentiellement de 75 à 150 eV, préférentiellement encore de 80 à 140 eV, mieux de 90 à 110 eV. Les espèces activées formées sont typiquement des radicaux ou des ions.

En cas de bombardement ionique lors du dépôt, il est possible d'effectuer un traitement par plasma concomitamment ou non au dépôt sous faisceau d'ions des couches A et/ou B. De préférence, le dépôt de ces couches est effectué sans l'assistance d'un plasma au niveau des substrats.

Le dépôt des couches A et/ou B, qui peut être réalisé selon des méthodes identiques ou différentes, s'effectue en présence d'une source d'oxygène lorsque le composé précurseur en question (A et/ou B) ne contient pas (ou pas suffisamment) d'atomes d'oxygène et que l'on souhaite que la couche correspondante contienne une certaine proportion d'oxygène. De même, le dépôt des couches A et/ou B s'effectue en présence d'une source d'azote lorsque le composé précurseur en question (A et/ou B) ne contient pas (ou pas suffisamment) d'atomes d'azote et que l'on souhaite que la couche correspondante contienne une certaine proportion d'azote. D'une manière générale, on préfère introduire du gaz oxygène avec le cas échéant une faible teneur en gaz azote, de préférence en l'absence de gaz azote.

Outre les couches A et B, d'autres couches du revêtement interférentiel peuvent être déposées sous bombardement ionique tel que décrit ci-dessus, c'est-à-dire en utilisant un bombardement au moyen d'un faisceau d'ions de la couche en cours de formation, émis de préférence par un canon à ions.

La méthode préférée pour la vaporisation des matériaux précurseurs des couches A et B, conduite sous vide, est le dépôt physique en phase vapeur, en particulier l'évaporation sous vide, généralement combinée à un chauffage des composés à évaporer. Elle peut être mise en jeu en utilisant des systèmes d'évaporation aussi divers qu'une source thermique à effet Joule (l'effet Joule est la manifestation thermique de la résistance électrique) ou un canon à électrons pour les précurseurs liquides ou solides, tout autre dispositif connu de l'homme du métier pouvant également être utilisé.

Les composés précurseurs organosiliciés A et B sont de préférence introduits dans l'enceinte à vide dans laquelle est réalisée la préparation des articles selon l'invention sous forme gazeuse, en contrôlant son débit. Généralement, ils ne sont pas vaporisés à l'intérieur de l'enceinte à vide (contrairement aux oxydes métalliques précurseurs). L'alimentation en composé organosilicié précurseur de la couche A ou B se situe à une distance de la sortie du canon à ions variant de préférence de 30 à 50 cm.

De préférence, les oxydes métalliques employés sont préchauffés de manière à se trouver dans un état fondu puis évaporés. Ils sont de préférence déposés par évaporation sous vide en utilisant un canon à électrons pour provoquer leur vaporisation.

Les composés A et B organosiliciés, précurseur respectifs des couches A et B, sont de nature organique et indépendants l'un de l'autre. Ils peuvent donc être identiques ou différents, et contiennent dans leur structure au moins un atome de silicium et au moins un atome de carbone. Ils comportent de préférence au moins une liaison Si-C, et comportent de préférence au moins un atome d'hydrogène. Selon un mode de réalisation, le composé A et/ou B comprend au moins un atome d'azote et/ou au moins un atome d'oxygène, de préférence au moins un atome d'oxygène.

La concentration de chaque élément chimique dans les couches A et B (métal M, Si, O, C, H, N...) peut être déterminée en utilisant la technique RBS (Rutherford Backscattering Spectrometry), ou ERDA (Elastic Recoil Detection Analysis).

Le pourcentage atomique en atomes de métal dans la couche B varie de préférence de 10 à 30 %. Le pourcentage atomique en atomes de carbone dans la couche B varie de préférence de 10 à 20 %. Le pourcentage atomique en atomes d'hydrogène dans la couche B varie de préférence de 10 à 30 %. Le pourcentage atomique en atomes de silicium dans la couche B varie de préférence de 10 à 20 %. Le pourcentage atomique en atomes d'oxygène dans la couche B varie de préférence de 20 à 40 %.

Le pourcentage atomique en atomes de métal dans la couche A varie de préférence de 0 à 15 %. Le pourcentage atomique en atomes de carbone dans la couche A varie de préférence de 10 à 25 %, mieux de 15 à 25 %. Le pourcentage atomique en atomes d'hydrogène dans la couche A varie de préférence de 10 à 40 %, mieux de 10 à 20 %. Le pourcentage atomique en atomes de silicium dans la couche A varie de préférence de 5 à 30 %, mieux de 15 à 25 %. Le pourcentage atomique en atomes d'oxygène dans la couche A varie de préférence de 20 à 60 %, mieux de 35 à 45 %.

Des exemples non limitatifs de composés organiques A et/ou B, cycliques ou non cycliques, sont les composés suivants : l'octaméthylcyclotétrasiloxane (OMCTS), le décaméthyl cyclopentasiloxane, le dodécaméthylcyclohexasiloxane, l'hexaméthyl cyclotrisiloxane, l'hexaméthyldisiloxane (HMDSO), l'octaméthyltrisiloxane, le décaméthyltétrasiloxane, le dodécaméthylpentasiloxane, le tétraéthoxysilane, le vinyltriméthylsilane, l'hexaméthyldisilazane, l'hexaméthyldisilane, i'hexaméthylcyclotrisilazane, le vinylméthyldiéthoxysilane, le divinyltétraméthyldisiloxane, le tétraméthyldisiloxane., le polydiméthylsiloxane (PDMS), le poly-phénylméthylsiloxane (PPMS) ou un tétraalkylsilane tel que le tétraméthylsilane.

De préférence, le composé A et/ou B comporte au moins un atome de silicium porteur d'au moins un groupe alkyle, de préférence en C1-C4, mieux au moins un atome de silicium porteur d'un ou de deux groupes alkyle identiques ou différents, de préférence en C1-C4, par exemple le groupe méthyle.

Les composés A et/ou B précurseurs préférés comportent un groupe Si-O-Si, mieux, un groupe divalent de formule (3) : 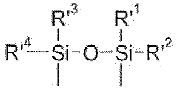 où R'¹ à R'⁴ désignent indépendamment des groupes alkyle ou vinyle linéaires ou ramifiés, de préférence en C1-C4, par exemple le groupe méthyle, des groupes aryle monocyclique ou polycyclique, hydroxyle ou des groupes hydrolysables. Des exemples non limitatifs de groupes hydrolysables sont les groupes H, halogène (chloro, bromo, iodo...), alcoxy, aryloxy, acyloxy, - NR¹R² où R¹ et R² désignent indépendamment un atome d'hydrogène, un groupe alkyle ou un groupe aryle, et -N(R³)-Si où R³ désigne un atome d'hydrogène, un groupe alkyle linéaire ou ramifié, de préférence en C1-C4 ou un groupe aryle, monocyclique ou polycyclique, de préférence monocyclique. Les groupes comportant un chaînon Si-O-Si ne sont pas considérés comme étant des "groupes hydrolysables" au sens de l'invention. Le groupe hydrolysable préféré est l'atome d'hydrogène.

Selon un autre mode de réalisation, le composé A et/ou B précurseur répond à la formule : 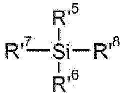 dans laquelle R'⁵, R'⁶, R'⁷, R'⁸ désignent indépendamment des groupes hydroxyle ou des groupes hydrolysables tels que des groupes OR, dans lesquels R est un groupe alkyle.

Selon un premier mode de réalisation, le composé A et/ou B comporte au moins un atome de silicium porteur de deux groupes alkyle identiques ou différents, de préférence en C1-C4. Selon ce premier mode de réalisation, le composé A et/ou B est de préférence un composé de formule (3) dans laquelle R'¹ à R'⁴ désignent indépendamment des groupes alkyle, de préférence en C1-C4, par exemple le groupe méthyle.

De préférence, le ou les atomes de silicium du composé A et/ou du composé B lorsqu'il est présent ne comportent aucun groupe hydrolysable ou groupe hydroxyle dans ce mode de réalisation.

Le ou les atomes de silicium du composé A et/ou B précurseur de la couche A et/ou B sont de préférence uniquement liés à des groupes alkyle et/ou des groupes comportant un chaînon -O-Si ou -NH-Si de façon à former un groupe Si-O-Si ou Si-NH-Si. Les composés précurseurs de la couche A et/ou B préférés sont l'OMCTS, le HMDSO, le décaméthyltétrasiloxane.

Il s'agit préférentiellement d'un polysiloxane cyclique de formule (4) : 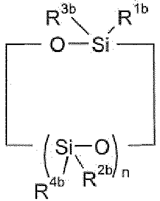 où n désigne un entier allant de 2 à 20, de préférence de 3 à 8, R^{1b} à R^{4b} représentent indépendamment des groupes alkyle linéaires ou ramifiés, de préférence en C1-C4 (par exemple le groupe méthyle), vinyle, aryle ou un groupe hydrolysable. Les membres préférés appartenant à ce groupe sont les octa-alkylcyclotétrasiloxanes (n = 3), de préférence l'octaméthylcyclotétrasiloxane (OMCTS). Dans certains cas, la couche A et/ou B est issue d'un mélange d'un certain nombre de composés de formule (4) où n peut varier dans les limites indiquées ci-dessus.

Selon un second mode de réalisation, le composé A et/ou B contient dans sa structure au moins un groupe Si-X', où X' est un groupe hydroxy ou un groupe hydrolysable, qui peut être choisi, sans limitation, parmi les groupes H, halogène, alcoxy, aryloxy, acyloxy, -NR¹R² où R¹ et R² désignent indépendamment un atome d'hydrogène, un groupe alkyle ou un groupe aryle, et - N(R³)-Si où R³ désigne un atome d'hydrogène, un groupe alkyle ou un groupe aryle.

Selon ce second mode de réalisation de l'invention, le composé A et/ou B contient de préférence dans sa structure au moins un groupe Si-H, c'est-à-dire constitue un hydrure de silicium. De préférence, l'atome de silicium du groupe Si-X' n'est pas lié à plus de deux groupes non hydrolysables tels que des groupes alkyle ou aryle.

Parmi les groupes X', les groupes acyloxy ont préférentiellement pour formule -OC(O)R⁴ où R⁴ est un groupe aryle préférentiellement en C6-C12, éventuellement substitué par un ou plusieurs groupes fonctionnels, ou alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les groupes aryloxy et alcoxy ont pour formule -O-R⁵ où R⁵ est un groupe aryle préférentiellement en C6-C12, éventuellement substitué par un ou plusieurs groupes fonctionnels, ou alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les halogènes sont préférentiellement F, Cl, Br ou I, les groupes X' de formule -NR¹R² peuvent désigner un groupe amino NH₂, alkylamino, arylamino, dialkylamino, diarylamino, R¹ et R² désignant indépendamment un atome d'hydrogène, un groupe aryle préférentiellement en C6-C12, éventuellement substitué par un ou plusieurs groupes fonctionnels, ou un groupe alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle, les groupes X' de formule -N(R³)-Si sont rattachés à l'atome de silicium par l'intermédiaire de leur atome d'azote et leur atome de silicium comporte naturellement trois autres substituants, où R³ désigne un atome d'hydrogène, un groupe aryle préférentiellement en C6-C12, éventuellement substitué par un ou plusieurs groupes fonctionnels, ou un groupe alkyle préférentiellement en C1-C6, linéaire ou ramifié, éventuellement substitué par un ou plusieurs groupes fonctionnels et pouvant comporter en outre une ou plusieurs doubles liaisons, tel que les groupes phényle, méthyle ou éthyle.

Le groupe acyloxy préféré est le groupe acétoxy. Le groupe aryloxy préféré est le groupe phénoxy. Le groupe halogène préféré est le groupe Cl. Les groupes alcoxy préférés sont les groupes méthoxy et éthoxy.

Dans le second mode de réalisation, le composé A et/ou B comporte de préférence au moins un atome de silicium porteur d'au moins un groupe alkyle, de préférence en C1-C4 linéaire ou ramifié, mieux au moins un atome de silicium porteur d'un ou de deux groupes alkyle identiques ou différents, de préférence en C1-C4, et d'un groupe X' (de préférence un atome d'hydrogène) directement lié à l'atome de silicium, X' ayant la signification indiquée précédemment. Le groupe alkyle préféré est le groupe méthyle. Le groupe vinyle peut également être utilisé à la place d'un groupe alkyle. De préférence, l'atome de silicium du groupe Si-X' est directement lié à au moins un atome de carbone.

De préférence, chaque atome de silicium du composé A et/ou B n'est pas lié directement à plus de deux groupes X', mieux n'est pas lié directement à plus d'un groupe X' (de préférence un atome d'hydrogène), mieux, chaque atome de silicium du composé A et/ou B est lié directement à un seul groupe X' (de préférence un atome d'hydrogène). De préférence, le composé A et/ou B comporte un ratio atomique Si/O égal à 1. De préférence, le composé A et/ou B comporte un ratio atomique C/Si <2, préférentiellement ≤ 1,8, mieux ≤ 1,6 et mieux encore ≤ 1,5, ≤ 1, 3 et de façon optimale égal à 1. De préférence encore, le composé A et/ou B comporte un ratio atomique C/O égal à 1. Selon un mode de réalisation, le composé A et/ou B ne comporte pas de groupe Si-N, mieux ne comporte pas d'atome d'azote.

Le ou les atomes de silicium du composé A et/ou B précurseur sont de préférence uniquement liés à des groupes alkyle, hydrogène et/ou des groupes comportant un chaînon -O-Si ou -NH-Si de façon à former un groupe Si-O-Si ou Si-NH-Si. Dans un mode de réalisation, le composé A et/ou B comporte au moins un groupe Si-O-Si-X' ou au moins un groupe Si-NH-SiX', X' ayant la signification indiquée précédemment et représentant de préférence un atome d'hydrogène.

Selon ce second mode de réalisation, le composé A et/ou B est de préférence un composé de formule (3) dans laquelle l'un au moins de R'¹ à R'⁴ désigne un groupe X' (de préférence un atome d'hydrogène), X' ayant la signification indiquée précédemment.

Selon ce second mode de réalisation, le composé A et/ou B est préférentiellement un polysiloxane cyclique de formule (5) : 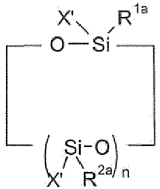 où X' a la signification indiquée précédemment et représente de préférence un atome d'hydrogène, n désigne un entier allant de 2 à 20, de préférence de 3 à 8, R^{1a} et R^{2a} représentent indépendamment un groupe alkyle de préférence en C1-C4 (par exemple le groupe méthyle), vinyle, aryle ou un groupe hydrolysable. Des exemples non limitatifs de groupes X' hydrolysables sont les groupes chloro, bromo, alcoxy, acyloxy, aryloxy, H. Les membres les plus courants appartenant à ce groupe sont les tétra-, penta- et hexa-alkylcyclotétrasiloxanes, de préférence les tétra-, penta- et hexa-méthylcyclotétrasiloxanes, le 2,4,6,8-tétraméthylcyclotétrasiloxane (TMCTS) étant le composé préféré. Dans certains cas, la couche A et/ou B est issue d'un mélange d'un certain nombre de composés ayant la formule ci-dessus où n peut varier dans les limites indiquées ci-dessus.

Selon un autre mode de réalisation, le composé A et/ou B est un alkylhydrosiloxane linéaire, mieux un méthylhydrosiloxane linéaire tel que par exemple le 1,1,1,3,5,7,7,7-octaméthyl tétrasiloxane, le 1,1,1,3,5,5,5-heptaméthyltrisiloxane, le 1,1,3,3,5,5-hexaméthyl trisiloxane.

Des exemples non-limitatifs de composés organiques A et/ou B précurseurs, cycliques ou non cycliques, conformes au second mode de réalisation, sont les composés suivants : le 2,4,6,8-tétraméthylcyclotétrasiloxane (TMCTS de formule (1)), le 2,4,6,8-tétraéthylcyclotétrasiloxane, le 2,4,6,8-tétraphénylcyclotétrasiloxane, le 2,4,6,8-tétraoctylcyclotétrasiloxane, le 2,2,4,6,6,8-hexaméthylcyclotétrasiloxane, le 2,4,6-triméthylcyclotrisiloxane, le cyclotétrasiloxane, le 1,3,5,7,9-pentaméthyl cyclopentasiloxane, le 2,4,6,8,10-hexaméthylcyclohexasiloxane, le 1,1,1,3,5,7,7,7-octaméthyl tétrasiloxane, le 1,1,3,3,5,5-hexaméthyltrisiloxane, le tétraméthyldisiloxane, le tétraéthoxysilane, le vinylméthyldiéthoxysilane, un hexaméthylcyclotrisilazane tel que le 3,4,5,6-hexaméthylcyclotrisilazane ou le 2,2,4,4,6,6-hexaméthylcyclotrisilazane, le 1,1,1,3,5,5,5-heptaméthyl trisiloxane, le tris(trimethylsiloxy)silane (de formule (2)), le 1,1,3,3-tétraméthyldisilazane, le 1,2,3,4,5,6,7,8-octaméthylcyclotétrasilazane, le nonaméthyl trisilazane, le tris(diméthylsilyl)amine, l'hexaméthyldisilazane.

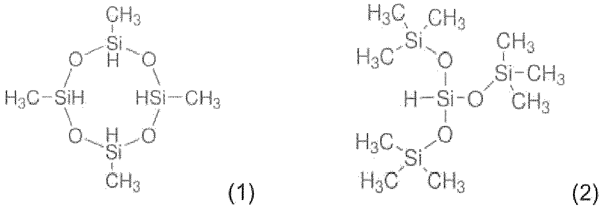

L'oxyde métallique précurseur de la couche B est de préférence un oxyde métallique de haut indice de réfraction, expression qui a été définie précédemment. Il peut être choisi parmi les oxydes métalliques et leurs mélanges convenant pour les couches de haut indice de réfraction décrites précédemment, ou parmi des oxydes métalliques sous-stœchiométriques tels qu'un oxyde de titane ou de zirconium sous-stœchiométrique, de formules respectives TiOx et ZrOx, avec x < 2, x variant de préférence de 0,2 à 1,2. Il s'agit de préférence de l'oxyde ZrO₂ ou d'un oxyde de zirconium sous-stœchiométrique tel que les composés ZrO, Zr₂O₃, ou Zr₃O₅. L'oxyde métallique précurseur est de préférence un oxyde de zirconium sous-stœchiométrique tel que ZrO.

La couche B peut être formée à partir d'un ou plusieurs oxydes métalliques, par exemple un mélange de ZrO et de Zr₂O₃, notamment par co-évaporation de ces composés.

De préférence, l'indice de réfraction de la couche B est supérieur ou égal à l'une au moins des valeurs suivantes : 1,7, 1,8, 1,9, 2,0, 2,05 et idéalement supérieur ou égal à 2,1.

La couche B de l'article final contient au moins un oxyde métallique ayant un indice de réfraction supérieur ou égal à 1,8. Cet oxyde métallique peut être le même que l'oxyde métallique précurseur utilisé pour former la couche B et décrit ci-dessus ou être différent de celui-ci, dans la mesure où le processus de dépôt de la couche B peut induire une modification de l'oxyde métallique précurseur telle qu'une oxydation. Il s'agit de préférence d'un oxyde de zirconium, en particulier le composé ZrO₂, ou d'un oxyde d'hafnium

L'utilisation d'oxyde de zirconium est avantageuse en raison de l'indice de réfraction élevé de cet oxyde métallique. L'indice de réfraction de l'oxyde ZrO₂ est effectivement de l'ordre de 2,15 à 632,8 nm. Ainsi, la couche B peut conserver un indice de réfraction élevé (de préférence ≥ 1,8) même si l'oxyde de zirconium est mélangé avec un composé B organosilicié d'indice de réfraction plus faible.

L'utilisation d'au moins un composé organosilicié B pour former la couche B, qui comporte de préférence des liaisons Si-C et éventuellement Si-O, permet de bénéficier de propriétés thermomécaniques améliorées par rapport aux matériaux de haut indice de réfraction traditionnels tels que TiO₂ ou ZrO₂, notamment la tenue à la température et la résistance à la rayure des substrats revêtus par les couches B selon l'invention, pour lesquelles on atteint des niveaux jusque-là inaccessibles par les technologies traditionnelles telles que le dépôt de couches purement inorganiques sous assistance ionique, tout en maintenant un indice de réfraction et une transparence élevés.

Selon un mode de réalisation de l'invention, la couche B comprend plus de 80 % en masse de composés issus du composé B et de l'oxyde métallique selon l'invention, par rapport à la masse totale de la couche B, de préférence plus de 90 %. Selon un mode de réalisation, la couche B est exclusivement formée par dépôt sous vide et sous bombardement ionique d'au moins un oxyde métallique et d'au moins un composé B organosilicié, à l'exclusion de tout autre précurseur.

De préférence, la couche B contient de 5 à 90 % en masse d'oxydes métalliques par rapport à la masse de la couche B. De préférence encore, la couche B contient de 5 à 70 % en masse de composés B organosiliciés par rapport à la masse de la couche B.

Selon un mode de réalisation préféré, la couche A n'est pas formée à partir de composés précurseurs inorganiques (minéraux) tels que des oxydes minéraux et ne contient donc pas de composés inorganiques tels que des oxydes métalliques. Dans ce cas, la couche A est une couche qui contient de préférence uniquement des composés organosiliciés.

Dans un mode de réalisation, lorsqu'ils sont présents, les composés inorganiques précurseurs de la couche A (généralement des oxydes métalliques ayant un indice de réfraction inférieur ou égal à 1,65), le sont dans une proportion telle que la couche A contient moins de 30 % en masse de composés inorganiques par rapport à la masse de la couche A, de préférence moins de 20 %, de préférence encore moins de 10 %, mieux moins de 5 %. De préférence, la teneur en composés inorganiques ou oxydes métalliques dans la couche A est inférieure à 10 % en masse par rapport à la masse de la couche A, mieux inférieure à 5 % et encore mieux inférieure à 1 %. La proportion de composé inorganique et de composé organique dans la couche A peut être déterminée, par exemple, en utilisant les indices de réfraction connus des composés inorganiques et des composés organiques et en mesurant l'épaisseur et la réflexion de la couche A. La proportion de composé organique dans la couche A peut être déterminée par interpolation à partir de l'indice de réfraction de la coucha A, en utilisant comme base l'indice de réfraction d'une couche constituée du composé organique et l'indice de réfraction d'une couche constituée du composé inorganique

La couche A contient plus de 70 % en masse de composés A organosiliciés par rapport à la masse de la couche A, mieux plus de 80 %, encore mieux plus de 90 % et idéalement 100 %.

L'indice de réfraction de la couche A est inférieur ou égal à 1,65, de préférence inférieur ou égal à 1,50. Selon des modes de réalisation de l'invention, l'indice de réfraction de la couche A est supérieur ou égal à 1,45, mieux supérieur à 1,47, mieux encore supérieur ou égal à 1,48 et idéalement supérieur ou égal à 1,49.

Lorsqu'elle est formée à partir d'un composé inorganique précurseur, la couche A de l'article final contient de préférence au moins un composé inorganique

Ce composé inorganique peut être le même que le composé inorganique précurseur utilisé pour former la couche A et décrit ci-dessus ou être différent de celui-ci, dans la mesure où le processus de dépôt de la couche A peut induire une modification du composé inorganique précurseur telle qu'une oxydation. Il s'agit de préférence d'un oxyde de silicium, en particulier le composé SiO₂.

Selon un mode de réalisation de l'invention, la couche A comprend plus de 80 % en masse de composés issus du composé A par rapport à la masse totale de la couche A, de préférence plus de 90 %. Selon un mode de réalisation, la couche A est exclusivement formée par dépôt sous vide et sous bombardement ionique d'au moins un composé A organosilicié et optionnellement d'au moins un composé inorganique, à l'exclusion de tout autre précurseur.

De préférence, la couche A et/ou B ne comprend pas de composé fluoré. De préférence encore, la couche A et/ou B ne contient pas une phase distincte d'oxydes métalliques ou de composés inorganiques, selon le cas. Les couches A et B étant formées par dépôt sous vide, elles ne comprennent pas d'hydrolysat de composé organosilicié et se distinguent donc des revêtements sol-gel obtenus par voie liquide.

La couche A et/ou B possède de préférence une épaisseur allant de 20 à 500 nm, de préférence encore de 25 à 250 nm, mieux de 30 à 200 nm. Lorsqu'elle constitue la couche externe du revêtement interférentiel, la couche A a préférentiellement une épaisseur allant de 60 à 200 nm. La durée du processus de dépôt, les débits et pressions sont ajustés de façon à obtenir les épaisseurs de revêtements désirées.

La couche A et/ou B possède de préférence un angle de contact statique avec l'eau supérieur ou égal à 70°, mieux supérieur ou égal à 80°, et encore mieux supérieur ou égal à 90°, variant de préférence de 70 à 95°.

Dans un mode de réalisation, l'article selon l'invention possède une couche B en contact direct avec la couche A, et une couche D comprenant au moins un oxyde métallique ayant un indice de réfraction supérieur ou égal à 1,8 déposée sur la couche B et en contact direct avec elle.

Selon un autre mode de réalisation, l'article selon l'invention comprend en outre une couche A selon l'invention constituant la couche externe du revêtement interférentiel et étant ou non en contact direct avec ladite couche D.

La couche D est une couche de haut indice de réfraction (de préférence ≥ 1,8), dont l'oxyde métallique ayant un indice de réfraction supérieur ou égal à 1,8 peut être choisi parmi les oxydes métalliques de haut indice de réfraction précédemment décrits, en particulier ceux envisagés pour la couche B. Il s'agit de préférence d'un oxyde de zirconium tel que l'oxyde ZrO₂ ou d'un oxyde de zirconium sous-stœchiométrique tel que les composés ZrO, Zr₂O₃, ou Zr₃O₅, idéalement ZrO₂. L'oxyde métallique précurseur de la couche D est de préférence un oxyde de zirconium sous-stœchiométrique tel que ZrO.

L'indice de réfraction de la couche D ou de l'oxyde métallique précurseur de la couche D est de préférence supérieur ou égal à 1,9, mieux 1,95, encore mieux 2,0 et idéalement 2,1. La couche D, lorsqu'elle est présente, a une épaisseur allant préférentiellement de 5 à 300 nm. De préférence, lorsque la couche D est présente, la somme des épaisseurs des couches D et B varie de 50 à 200 nm, mieux de 75 à 175 nm, et encore mieux de 100 à 175 nm.

Le dépôt de la couche D peut être effectué selon les mêmes techniques que celles présentées pour les couches A et B. Ainsi, la couche D est de préférence déposée sous vide, typiquement par évaporation, de préférence sous l'assistance d'une source d'ions, les ions étant issus de préférence d'un canon à ions.

De préférence, la couche D n'est pas formée à partir de composés précurseurs organiques, en particulier de composés organosiliciés et ne contient donc pas de composés organiques tels que des composés organosiliciés. Dans ce cas, la couche D est une couche de nature inorganique, qui contient de préférence uniquement des oxydes métalliques. De préférence, la teneur en composés organiques ou composés organosiliciés dans la couche D est inférieure à 10 % en masse par rapport à la masse de la couche D, mieux inférieure à 5 % et encore mieux inférieure à 1 %.

De préférence, la couche D est formée à la suite de la couche B en arrêtant simplement l'injection dans l'enceinte à vide du composé organosilicié B lorsque le dépôt de la couche B est achevé, l'injection de l'oxyde métallique étant poursuivie. Dans ce cas, l'oxyde métallique précurseur de la couche B et celui de la couche D sont identiques. Ce mode de dépôt est avantageux car aucun défaut d'adhésion entre les couches B et D ne peut alors être observé.

Du point de vue des performances optiques, le fait de former une couche D à base d'oxyde métallique de haut indice de réfraction, de préférence sous assistance ionique et de préférence exempte de composé organique permet d'obtenir une couche d'indice de réfraction élevé et de compenser la baisse de performance optique liée à l'indice de réfraction plus faible de la couche B co-évaporée sous-jacente qui découle de l'utilisation d'un composé organosilicié.

Selon le second mode de réalisation de l'invention, le revêtement interférentiel comporte au moins une couche C, déposée sur la couche A et en contact direct avec elle, ladite couche C comprenant un oxyde de silicium et ayant une épaisseur inférieure ou égale à 15 nm, et étant en contact direct avec une couche E comprenant au moins un oxyde métallique ayant un indice de réfraction supérieur ou égal à 1,8.

La couche C est une couche de bas indice de réfraction (≤ 1,65), dont l'indice de réfraction est de préférence inférieur ou égal à 1,50. Selon des modes de réalisation de l'invention, l'indice de réfraction de la couche C est généralement supérieur ou égal à 1,45, mieux supérieur à 1,47, mieux encore supérieur ou égal à 1,48 et idéalement supérieur ou égal à 1,49.

L'oxyde de silicium de la couche C peut être choisi parmi la silice (SiO₂) et les oxydes de silicium sous-stœchiométriques, de formule SiOx, avec x < 2, x variant de préférence de 0,2 à 1,2. Il s'agit de préférence des oxydes SiO₂ ou SiO ou de leurs mélanges, idéalement SiO₂.

De préférence, la couche C contient au moins 50 % en masse d'oxydes de silicium, par rapport à la masse totale de la couche C, mieux 75 % ou plus et encore mieux 90 % ou plus, idéalement 95 % ou plus. Selon un mode de réalisation préféré, la couche C constitue une couche formée exclusivement d'oxydes de silicium.

De préférence, la couche C est une couche à base de silice contenant au moins 50 % en masse de silice, par rapport à la masse totale de la couche C, mieux 75 % ou plus et encore mieux 90 % ou plus, idéalement 95 % ou plus. Selon un mode de réalisation préféré, la couche C constitue une couche formée exclusivement de silice.

La couche C, lorsqu'elle est présente, est une fine couche ayant une épaisseur préférentiellement inférieure ou égale à 10 nm, qui varie de préférence de 2 à 10 nm, mieux de 5 à 10 nm.

La couche E est une couche de haut indice de réfraction (de préférence ≥ 1,8), dont l'oxyde métallique ayant un indice de réfraction supérieur ou égal à 1,8 peut être choisi parmi les oxydes métalliques de haut indice de réfraction précédemment décrits, en particulier ceux envisagés pour la couche B. Il s'agit de préférence d'un oxyde de zirconium tel que l'oxyde ZrO₂ ou d'un oxyde de zirconium sous-stœchiométrique tel que les composés ZrO, Zr₂O₃, ou Zr₃O₅, idéalement ZrO₂. L'oxyde métallique précurseur de la couche E est de préférence un oxyde de zirconium sous-stœchiométrique tel que ZrO.

L'indice de réfraction de la couche E ou de l'oxyde métallique précurseur de la couche E est de préférence supérieur ou égal à 1,9, mieux 1,95, encore mieux 2,0 et idéalement 2,05.

La couche E, lorsqu'elle est présente, a une épaisseur allant préférentiellement de 5 à 300 nm, mieux de 50 à 300 nm. De préférence, lorsque la couche E est présente, la somme des épaisseurs des couches E et C varie de 30 à 315 nm, mieux de 75 à 175 nm, et encore mieux de 100 à 175 nm.

Le dépôt de la couche C ou E peut être effectué selon les mêmes techniques que celles présentées pour les couches A et B. Ainsi, les couches C et/ou E sont de préférence déposées sous vide, typiquement par évaporation, de préférence sous l'assistance d'une source d'ions, mieux d'un canon à ions.

De préférence, les couches C et/ou E ne sont pas formées à partir de composés précurseurs organiques, en particulier de composés organosiliciés et ne contiennent donc pas de composés organiques tels que des composés organosiliciés. Dans ce cas, les couches C et/ou E sont des couches de nature inorganique, qui contiennent de préférence uniquement des oxydes métalliques. De préférence, la teneur en composés organiques ou composés organosiliciés dans la couche C ou E est inférieure à 10 % en masse par rapport à la masse de la couche C ou E, mieux inférieure à 5 % et encore mieux inférieure à 1 %.

Comme cela a été expliqué précédemment, il est difficile de faire adhérer une couche à base d'oxydes métalliques de haut indice de réfraction E directement à une couche A selon l'invention.

Le second mode de réalisation de l'invention permet de résoudre ce problème d'adhérence en intercalant entre la couche A et la couche E de haut indice de réfraction une fine couche à base d'oxyde de silicium. Le premier mode de réalisation de l'invention, utilisant une couche de haut indice de réfraction modifiée par un composé organosilicié, en l'occurrence une couche B, est toutefois préféré, car il permet d'accéder à un article ayant des propriétés thermomécaniques et de résistance à l'abrasion supérieures.

La nature des composés précurseurs employés, leurs quantités respectives (qui peuvent être modulées en ajustant les débits évaporés), les conditions de dépôt, notamment la durée du dépôt, sont des exemples de paramètres que l'homme du métier saura faire varier pour parvenir au revêtement interférentiel comprenant des couches A à E présentant l'ensemble des propriétés souhaitées, en particulier à l'aide des exemples de la présente demande.

Parmi ses propriétés avantageuses, l'article selon l'invention possède une résistance accrue à la courbure. Ceci découle de la nature des couches A et B de l'invention, qui possèdent des allongements à la rupture supérieurs à ceux des couches inorganiques, et peuvent subir des déformations sans se fissurer.

La température critique d'un article revêtu selon l'invention est de préférence supérieure ou égale à 70°C, mieux supérieure ou égale à 80°C et encore mieux supérieure ou égale à 90°C. Dans la présente demande, la température critique d'un article ou d'un revêtement est définie comme étant celle à partir de laquelle on observe l'apparition de craquelures dans l'empilement présent à la surface du substrat, ce qui traduit une dégradation du revêtement. Cette température critique élevée est due à la présence de la couche A (et de la couche B lorsqu'elle est présente) à la surface de l'article, comme démontré dans la partie expérimentale. Par ailleurs, les couches A et B obtenues possèdent une aptitude plus faible à se charger en eau que des couches inorganiques évaporées. Les couches A et B obtenues selon l'invention ont une excellente stabilité dans le temps de leurs propriétés optiques.

Grâce à leurs propriétés thermomécaniques améliorées, les couches A et B peuvent notamment être appliquées sur une seule face d'une lentille semi-finie, généralement sa face avant, l'autre face de cette lentille devant encore être usinée et traitée. L'empilement présent sur la face avant de la lentille ne sera pas dégradé par l'accroissement de température générée par les traitements que subira la face arrière lors du durcissement des revêtements qui auront été déposés sur cette face arrière ou toute autre action susceptible d'augmenter la température de la lentille.

De préférence, le facteur moyen de réflexion dans le domaine visible (400-700 nm) d'un article revêtu d'un revêtement interférentiel selon l'invention, noté Rₘ, est inférieur à 2,5 % par face, mieux inférieur à 2 % par face et encore mieux inférieur à 1 % par face de l'article. Dans un mode de réalisation optimal, l'article comprend un substrat dont les deux surfaces principales sont revêtues d'un revêtement interférentiel selon l'invention et présente une valeur de Rₘ totale (cumul de réflexion due aux deux faces) inférieure à 1%. Les moyens pour parvenir à de telles valeurs de Rₘ sont connus de l'homme du métier.

Le facteur de réflexion lumineux Rᵥ d'un revêtement interférentiel selon l'invention est inférieur à 2,5 % par face, de préférence inférieur à 2 % par face, mieux inférieur à 1 % par face de l'article, mieux ≤ 0,75 %, mieux encore ≤ 0,5 %.

Dans la présente demande, le "facteur moyen de réflexion" Rₘ (moyenne de la réflexion spectrale sur l'ensemble du spectre visible entre 400 et 700 nm) et le facteur de réflexion lumineux Rᵥ sont tels que définis dans la norme ISO 13666:1998, et mesurés conformément à la norme ISO 8980-4.

Dans certaines applications, il est préférable que la surface principale du substrat soit revêtue d'un ou plusieurs revêtements fonctionnels préalablement au dépôt du revêtement interférentiel. Ces revêtements fonctionnels classiquement utilisés en optique peuvent être, sans limitation, une couche de primaire améliorant la résistance au choc et/ou l'adhésion des couches ultérieures dans le produit final, un revêtement anti-abrasion et/ou anti-rayures, un revêtement polarisé, un revêtement photochrome, électrochrome ou un revêtement coloré, en particulier une couche de primaire revêtue d'une couche anti-abrasion et/ou anti-rayures. Ces deux derniers revêtements sont décrits plus en détail dans les demandes WO 2008/015364 et WO 2010/109154.

L'article selon l'invention peut également comporter des revêtements formés sur le revêtement interférentiel, capables de modifier ses propriétés de surface, tels qu'un revêtement hydrophobe et/ou oléophobe (top coat antisalissure) ou un revêtement antibuée. Ces revêtements sont de préférence déposés sur la couche externe du revêtement interférentiel, qui peut être une couche A. Leur épaisseur est en général inférieure ou égale à 10 nm, de préférence de 1 à 10 nm, mieux de 1 à 5 nm. Ils sont respectivement décrits dans les demandes WO 2009/047426 et WO 2011/080472.

Typiquement, un article selon l'invention comprend un substrat successivement revêtu d'une couche de primaire d'adhésion et/ou antichoc, d'un revêtement anti-abrasion et/ou anti-rayure, d'un revêtement interférentiel optionnellement antistatique comprenant notamment une couche A et une couche B ou C selon l'invention, et d'un revêtement hydrophobe et/ou oléophobe.

L'invention concerne également un procédé de fabrication d'un article tel que défini ci-dessus, comprenant au moins les étapes suivantes :
- fournir un article comprenant un substrat ayant au moins une surface principale,
- déposer sur ladite surface principale du substrat une couche A présentant un indice de réfraction inférieur ou égal à 1,65 et contenant plus de 70 % en masse de composés A organosiliciés par rapport à la masse de la couche A,
- déposer sur ladite couche A :
   - soit une couche B ayant un indice de réfraction supérieur à 1,65 et contenant au moins un oxyde métallique ayant un indice de réfraction supérieur à 1,8, et optionnellement déposer directement sur ladite couche B une couche D comprenant au moins un oxyde métallique ayant un indice de réfraction supérieur ou égal à 1,8,
   - soit une couche C comprenant un oxyde de silicium et ayant une épaisseur inférieure ou égale à 15 nm, et déposer directement sur ladite couche C une couche E comprenant au moins un oxyde métallique ayant un indice de réfraction supérieur ou égal à 1,8,
- récupérer un article comprenant un substrat ayant une surface principale revêtue d'un revêtement interférentiel comprenant, dans le sens de l'éloignement du substrat, une couche A en contact direct avec une couche B ou une couche A en contact direct avec une couche C en contact direct avec une couche E,
ladite couche A ayant été obtenue par dépôt sous vide, assisté par une source d'ions, d'au moins un composé A organosilicié, et ladite couche B, lorsqu'elle est présente, ayant été obtenue par dépôt sous vide, assisté par une source d'ions, d'au moins un oxyde métallique et d'au moins un composé B organosilicié.

L'invention est illustrée, de façon non limitative, par les exemples suivants.

### EXEMPLES

### 1. Procédures générales

Les articles employés dans les exemples comprennent un substrat de lentille ORMA^{®} ESSILOR de 65 mm de diamètre, de puissance -2,00 dioptries et d'épaisseur 1,2 mm, revêtu sur sa face concave du revêtement de primaire antichoc et du revêtement anti-abrasion et anti-rayures (hard coat) divulgués dans la partie expérimentale de la demande WO 2010/109154, et un revêtement interférentiel antireflet comprenant une couche A selon l'invention et une couche B ou C selon l'invention.

Le bâti de dépôt sous vide est une machine Leybold LAB1100+ équipée d'un canon à électrons pour l'évaporation des matériaux précurseurs, d'un évaporateur thermique, d'un canon à ions KRI EH 1000 F (de la société Kaufman & Robinson Inc.) pour la phase préliminaire de préparation de la surface du substrat par des ions argon (IPC), ainsi que pour le dépôt des couches sous bombardement ionique (IAD), et d'un système d'introduction de liquide, utilisé lorsque le composé organosilicié précurseur notamment de la couche A et/ou B est un liquide dans les conditions normales de température et de pression (cas du décaméthyltétrasiloxane). Ce système comprend un réservoir contenant le composé précurseur liquide de la couche en question, des résistances pour chauffer le réservoir et les tubes reliant le réservoir de précurseur liquide à la machine de dépôt sous vide, un débitmètre pour la vapeur de la société MKS (MKS1150C), porté à une température de 30-120°C lors de son utilisation, selon le débit de décaméthyltétrasiloxane vaporisé, qui varie de préférence de 0,01 à 0,8 g/min (1 à 50 sccm) (la température est de 120°C pour un débit de 0,3 g/min (20 sccm) de décaméthyltétrasiloxane).

La vapeur de décaméthyltétrasiloxane sort d'un tuyau en cuivre à l'intérieur de la machine, à une distance d'environ 30 cm du canon à ions. Des débits d'oxygène et éventuellement d'argon sont introduits à l'intérieur du canon à ions. Préférentiellement, il n'est pas introduit d'argon ni aucun autre gaz rare à l'intérieur du canon à ions.

Les couches A, B et/ou D selon l'invention sont formées par évaporation sous vide assistée par faisceau d'ions oxygène et éventuellement argon pendant le dépôt (source d'évaporation : canon à électrons) de décaméthyltétrasiloxane (couches A, B), fourni par la société Sigma-Aldrich et d'un oxyde de zirconium sous-stœchiométrique (ZrO) fourni par la société Umicore (couches B, D).

Sauf indication contraire, les épaisseurs mentionnées dans la présente demande sont des épaisseurs physiques. Plusieurs échantillons de chaque verre ont été préparés.

### 2. Modes opératoires

Le procédé de préparation des articles d'optique selon l'invention comprend l'introduction du substrat revêtu du revêtement de primaire et du revêtement anti-abrasion définis ci-dessus dans l'enceinte de dépôt sous vide, le préchauffage du réservoir, des tuyaux et du débitmètre à vapeur à la température choisie (~ 15 min), une étape de pompage primaire, puis de pompage secondaire pendant 400 s permettant l'obtention d'un vide secondaire (~2. 10⁻⁵ mbar, pression lue sur une jauge Bayard-Alpert), une étape d'activation de la surface du substrat par un faisceau d'ions argon (IPC : 1 minute, 100 V, 1 A, le canon à ions restant en fonctionnement à la fin de cette étape), puis le dépôt par évaporation d'un revêtement antireflet comprenant au moins une couche A.

Dépôt d'une couche A selon l'invention : Le canon à ions ayant été démarré avec de l'argon, de l'oxygène est ajouté dans le canon à ions avec un débit programmé, le courant d'anode souhaité est programmé (3 A) et le débit d'argon est éventuellement arrêté, selon les conditions de dépôt souhaitées. D'une manière générale, le procédé selon l'invention est effectué avec de l'oxygène (débit d'O₂ dans le canon à ions au niveau de la source ionique : 20 sccm) introduit dans le canon à ions, en l'absence de gaz rare. Le décaméthyltétrasiloxane est introduit dans l'enceinte (débit d'injection : 20 sccm). L'alimentation en ce composé est arrêtée une fois l'épaisseur souhaitée obtenue, puis le canon à ions est éteint. Une couche B ou C selon l'invention est alors déposée directement sur la couche A.

Dépôt d'une couche B selon l'invention : L'oxyde de zirconium sous-stœchiométrique ZrO (précurseur inorganique) est préchauffé de manière à se trouver dans un état fondu puis évaporé à l'aide d'un canon à électrons, l'obturateur du canon à ions et celui du canon à électrons étant ouverts simultanément (débit d'O₂ dans le canon à ions au niveau de la source ionique : 20 sccm, pas de débit d'argon, courant d'anode : 3 A). Dans le même temps, le décaméthyltétrasiloxane est introduit dans l'enceinte de dépôt sous forme gazeuse, à un débit d'injection contrôlé de 7 sccm. La couche obtenue présente un indice de réfraction de 1,8.

Dépôt d'une couche C selon l'invention (couche de silice) : a été effectué de façon classique par évaporation sous vide de SiO₂ sans assistance ionique.

Dépôt d'une couche D selon l'invention : Les couches D ont été obtenues par évaporation d'oxyde de zirconium sous assistance ionique (débit d'O₂ dans le canon à ions au niveau de la source ionique : 20 sccm, pas de débit d'argon, courant d'anode : 3 A), et possèdent un indice de réfraction de 2,08.

Le dépôt des autres couches d'oxydes métalliques (ne contenant aucun composé organosilicié) a été effectué de façon classique par évaporation sous vide de l'oxyde métallique adéquat (oxyde de zirconium, SiO₂...), sans assistance ionique.

L'épaisseur des couches déposées a été contrôlée en temps réel au moyen d'une microbalance à quartz, en modifiant si besoin la vitesse de dépôt en ajustant le courant du canon à électrons. Une fois l'épaisseur souhaitée obtenue, le ou les obturateurs ont été fermés, le ou les canons à ions et électrons arrêtés, et les débits de gaz (oxygène, éventuellement argon et vapeurs de décaméthyltétrasiloxane) ont été arrêtés.

Une étape de ventilation finale a été réalisée une fois le dépôt de l'empilement achevé.

Plusieurs exemples comparatifs ont été réalisés, en remplaçant la ou les couches A selon l'invention par des couches de SiO₂, et en remplaçant les couches B et D selon l'invention par des couches de ZrO₂. Ainsi, l'exemple comparatif 1 diffère des exemples 1 à 4 par la suppression de tous les composés organosiliciés dans les couches du revêtement antireflet, et l'exemple comparatif 5 diffère de l'exemple 5 par la suppression de tous les composés organosiliciés dans les couches du revêtement antireflet.

### 3. Caractérisations

La température critique de l'article est mesurée 24 heures et/ou une semaine après sa préparation, de la façon indiquée dans la demande WO 2008/001011.

Sauf indication contraire, les indices de réfraction auxquels il est fait référence dans la présente invention sont exprimés pour une longueur d'onde de 632,8 nm et ont été mesurés par ellipsométrie à une température de 20-25°C.

Le test de résistance à la courbure, décrit dans la demande WO 2013/098531, permet d'évaluer la capacité d'un article possédant une courbure à subir une déformation mécanique. Le mode de sollicitation de ce test est représentatif de la sollicitation chez l'opticien pour le montage du verre, c'est-à-dire la "compression" du verre pour l'insérer dans une monture métallique. Le résultat du test, réalisé un mois après la préparation des verres, est la déformation critique D en mm que peut subir le verre avant l'apparition de fissures. Plus la valeur de la déformation est élevée, meilleure est la résistance à la déformation mécanique appliquée. D'une manière générale, les revêtements interférentiels selon l'invention ont des valeurs de déformation critique variant de 0,7 à 1,9 mm, mieux de 0,8 mm à 1,6 mm et encore mieux de 0,9 à 1,5 mm.

Les propriétés d'adhésion de l'ensemble du revêtement interférentiel au substrat ont été vérifiées sur la face convexe de la lentille au moyen du test communément appelé "n×10 coups", en suivant la procédure décrite dans les demandes internationales WO 2010/109154 et WO 99/49097. L'appréciation consiste à relever le nombre de sollicitations que peut supporter une lentille avant l'apparition d'un défaut. Par conséquent, plus la valeur obtenue au test n×10 coups est élevée, meilleure est l'adhésion du revêtement interférentiel au substrat.

La résistance à l'abrasion de l'article a été évaluée par détermination des valeurs BAYER ASTM (Bayer sable) sur les substrats revêtus du revêtement antireflet selon les méthodes décrites dans la demande WO 2008/001011 (norme ASTM F 735.81). Plus la valeur obtenue au test BAYER est élevée, plus la résistance à l'abrasion est élevée. Ainsi, la valeur de Bayer ASTM (Bayer sable) est qualifiée de bonne lorsqu'elle est supérieure ou égale à 3,4 et inférieure à 4,5 et d'excellente pour des valeurs de 4,5 et plus.

La dureté, ou résistance à la rayure, a été a été évaluée grâce au test dit de la paille de fer (pdf manuel, ou test à la laine d'acier), tel que décrit dans la demande WO 2008/062142. Plus la note obtenue est élevé (note allant de 1 à 5), plus la résistance à la rayure du verre est faible.

### 4. Résultats

Les tableaux ci-dessous présentent les performances optiques et mécaniques de différents articles selon l'invention ou articles comparatifs ainsi que les conditions de dépôt des différentes couches et leurs épaisseurs.

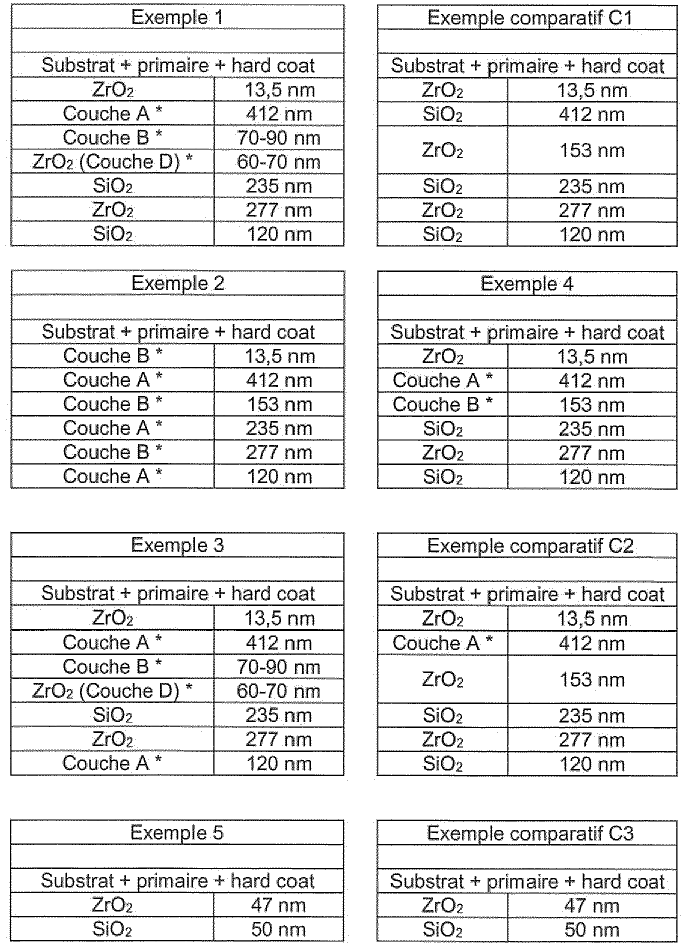

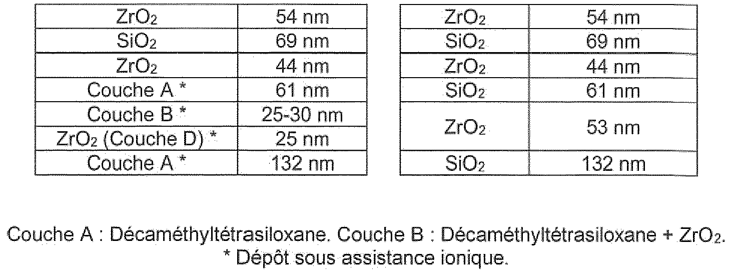

| Exemple 6 | |
|---|---|
| | |

| Substrat + primaire + hard coat | |
|---|---|
| ZrO₂ | 13,5 nm |
| Couche A * | 412 nm |
| Couche C | 7-10 nm |
| ZrO₂ | 153 nm |
| SiO₂ | 235 nm |
| ZrO₂ | 277 nm |
| SiO₂ | 120 nm |

| | |
|---|---|
| Couche A : Décaméthyltétrasiloxane. Couche C : SiO₂ * Dépôt sous assistance ionique. | |

| Exemple | Test Bayer ASTM | Test nx10 coups | Test paille de fer | T critique [°C] à t+24h | T critique [°C] à t+ 1 semaine | Résistance à la courbure, déformation en mm avant craquelure |
|---|---|---|---|---|---|---|
| 1 | 6,7 | 13 | 3 | 70 | 60 | 0,69 |
| C1 | 6,8 | 13 | 3 | 60 | 50 | 0,32 |
| C2 | | 3-6 | | | | |
| 2 | 5,5 | 13 | 1 à 3 | 120 | 120 | 1,45 |
| 3 | 6,2 | 13 | 3 | 80 | 70 | 0,91 |
| 4 | 7,0 | 13 | 3 | 70 | 60 | 0,65 |
| 5 | 5,1 | 13 | 1 | 90 | 90 | 1,02 |
| C3 | 1,6 | 13 | 3 | 70 | 50 | 0,44 |
| 6 | 6,8 | 13 | 3 | 60 | 60 | 0,66 |

L'article de l'exemple comparatif 2, possédant une couche de ZrO₂ déposée directement sur une couche A selon l'invention, présente d'importantes craquelures sur toute la surface du verre, et ceci indépendamment des paramètres de dépôt de la couche A. Les inventeurs pensent, sans toutefois être limité à une quelconque théorie, que la fragilité de cette structure se situe à l'interface de la couche A et de la couche ZrO₂ déposée à la suite. Le test nx10 coups met en évidence un important problème d'adhérence.

Les articles des exemples 1 à 5 ne présentent aucune craquelure à la fin de leur préparation et ont révélé de bonnes performances lors des différents tests de durabilité réalisés. Ils présentent des températures critiques supérieures et des résistances à la courbure 2 à 4,5 fois plus élevées que les articles des exemples comparatifs dont les couches antireflet ne contiennent aucun composé organosilicié.

L'utilisation d'une couche D obtenue par évaporation d'oxyde de zirconium dans les exemples 1, 3 et 5 est très avantageuse d'un point de vue optique. Son indice de réfraction élevé (n = 2,08 à 632,8 nm) permet notamment de compenser la perte d'indice de réfraction dans la couche B sous-jacente (n = 1,8 à 632,8 nm) liée à l'utilisation d'un composé organosilicié.

Les meilleurs résultats en termes de résistance à la courbure et de température critique ont été obtenus pour l'exemple 2, dont toutes les couches de l'empilement antireflet ont été formées sous assistance ionique et sont obtenues à partir d'un composé organosilicié et d'un oxyde métallique (SiO₂ pour les couches de bas indice de réfraction, ZrO₂ pour les couches de haut indice de réfraction).

## Revendications

1. Article comprenant un substrat ayant au moins une surface principale revêtue d'un revêtement interférentiel comprenant, dans le sens de l'éloignement du substrat :
- une couche A obtenue par dépôt sous vide, assisté par une source d'ions, d'au moins un composé A organosilicié, ladite couche A présentant un indice de réfraction inférieur ou égal à 1,65 et contenant plus de 70 % en masse de composés A organosiliciés par rapport à la masse de la couche A, et, en contact direct avec cette couche A,
- soit une couche B obtenue par dépôt sous vide, assisté par une source d'ions, d'au moins un oxyde métallique et d'au moins un composé B organosilicié, ladite couche B présentant un indice de réfraction supérieur à 1,65 et contenant au moins un oxyde métallique ayant un indice de réfraction supérieur ou égal à 1,8,
- soit une couche C comprenant un oxyde de silicium et ayant une épaisseur inférieure ou égale à 15 nm, en contact direct avec une couche E comprenant au moins un oxyde métallique ayant un indice de réfraction supérieur ou égal à 1,8.

2. Article selon la revendication 1, **caractérisé en ce que** le dépôt assisté par une source d'ions est un bombardement ionique.

3. Article selon l'une quelconque des revendications précédentes, **caractérisé en ce que** le composé A comporte au moins un groupe divalent de formule : 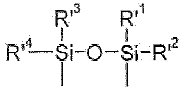 où R'¹ à R'⁴ désignent indépendamment des groupes alkyle, vinyle, aryle, hydroxyle ou des groupes hydrolysables, ou **en ce que** le composé A répond à la formule : 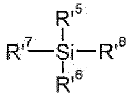 dans laquelle R'⁵, R'⁶, R'⁷, R'⁸ désignent indépendamment des groupes hydroxyle ou des groupes hydrolysables tels que des groupes OR, dans lesquels R est un groupe alkyle.

4. Article selon l'une quelconque des revendications précédentes, **caractérisé en ce que** le composé A est choisi parmi l'octaméthylcyclotétrasiloxane, le décaméthyltétrasiloxane, le 2,4,6,8-tétraméthylcyclotétrasiloxane, l'hexaméthyldisiloxane, le décaméthylcyclopentasiloxane, le dodécaméthylpentasiloxane.

5. Article selon l'une quelconque des revendications précédentes, **caractérisé en ce que** ladite couche A n'est pas formée à partir de composés précurseurs inorganiques.

6. Article selon l'une quelconque des revendications précédentes, **caractérisé en ce que** la couche A a une épaisseur allant de 20 à 500 nm.

7. Article selon l'une quelconque des revendications précédentes, **caractérisé en ce qu'**il possède une couche B déposée sur la couche A et en contact direct avec elle, dont le composé B comporte au moins un groupe divalent de formule : 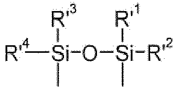 où R'¹ à R'⁴ désignent indépendamment des groupes alkyle, vinyle, aryle, hydroxyle ou des groupes hydrolysables, ou **en ce que** le composé B répond à la formule : 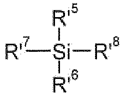 dans laquelle R'⁵, R'⁶, R'⁷, R'⁸ désignent indépendamment des groupes hydroxyle ou des groupes hydrolysables tels que des groupes OR, dans lesquels R est un groupe alkyle.

8. Article selon l'une quelconque des revendications précédentes, **caractérisé en ce qu'**il possède une couche B déposée sur la couche A et en contact direct avec elle, dont l'oxyde métallique ayant un indice de réfraction supérieur ou égal à 1,8 est un oxyde de zirconium ou un oxyde d'hafnium.

9. Article selon l'une quelconque des revendications précédentes, **caractérisé en ce qu'**il possède ladite couche B en contact direct avec ladite couche A, et une couche D comprenant au moins un oxyde métallique ayant un indice de réfraction supérieur ou égal à 1,8 déposée sur la couche B et en contact direct avec elle, la couche D étant de préférence déposée sous assistance ionique.

10. Article selon la revendication 9, **caractérisé en ce que** ladite couche D n'est pas formée à partir de composés précurseurs organiques.

11. Article selon l'une quelconque des revendications 1 à 6, **caractérisé en ce qu'**il possède une couche C déposée sur la couche A et en contact direct avec elle, la couche C comprenant au moins 50 % en masse de silice, par rapport à la masse totale de la couche C.

12. Article selon l'une quelconque des revendications 1 à 6 et 11, **caractérisé en ce qu'**il possède une couche C ayant une épaisseur allant de 2 à 10 nm déposée sur la couche A et en contact direct avec elle.

13. Article selon l'une quelconque des revendications précédentes, **caractérisé en ce que** le revêtement interférentiel est un revêtement antireflet.

14. Article selon l'une quelconque des revendications précédentes, **caractérisé en ce qu'**il est une lentille optique, de préférence une lentille ophtalmique.

15. Article selon l'une quelconque des revendications précédentes, **caractérisé en ce que** le revêtement interférentiel comprend ladite couche C en contact direct avec ladite couche E, ladite couche E n'étant pas formée à partir de composés précurseurs organiques.

16. Procédé de fabrication d'un article selon l'une quelconque des revendications précédentes, comprenant au moins les étapes suivantes :
- fournir un article comprenant un substrat ayant au moins une surface principale,
- déposer sur ladite surface principale du substrat une couche A présentant un indice de réfraction inférieur ou égal à 1,65 et contenant plus de 70 % en masse de composés A organosiliciés par rapport à la masse de la couche A,
- déposer sur ladite couche A :
- soit une couche B ayant un indice de réfraction supérieur à 1,65 et contenant au moins un oxyde métallique ayant un indice de réfraction supérieur à 1,8,
- soit une couche C comprenant un oxyde de silicium et ayant une épaisseur inférieure ou égale à 15 nm, et déposer directement sur ladite couche C une couche E comprenant au moins un oxyde métallique ayant un indice de réfraction supérieur ou égal à 1,8,
- récupérer un article comprenant un substrat ayant une surface principale revêtue d'un revêtement interférentiel comprenant, dans le sens de l'éloignement du substrat, une couche A en contact direct avec une couche B ou une couche A en contact direct avec une couche C en contact direct avec une couche E,
ladite couche A ayant été obtenue par dépôt sous vide, assisté par une source d'ions, d'au moins un composé A organosilicié, et ladite couche B, lorsqu'elle est présente, ayant été obtenue par dépôt sous vide, assisté par une source d'ions, d'au moins un oxyde métallique et d'au moins un composé B organosilicié.

## Patentansprüche

1. Artikel, der ein Substrat umfasst, das mindestens eine Hauptfläche aufweist, die mit einer Interferenzbeschichtung beschichtet ist, die in der Richtung vom Substrat weg Folgendes umfasst:
- eine Schicht A, die mittels einer durch eine Ionenquelle unterstützten Vakuumabscheidung mindestens einer siliciumorganischen Verbindung A erhalten wird, wobei die Schicht A einen Brechungsindex kleiner oder gleich 1,65 aufweist und mehr als 70 Gew.-% siliciumorganische Verbindungen A, bezogen auf die Masse der Schicht A, und in direktem Kontakt mit dieser Schicht A enthält,
- entweder eine Schicht B, die mittels einer durch eine Ionenquelle unterstützten Vakuumabscheidung mindestens eines Metalloxids und mindestens einer siliciumorganischen Verbindung B erhalten wird, wobei die Schicht B einen Brechungsindex größer 1,65 aufweist und mindestens ein Metalloxid mit einem Brechungsindex größer oder gleich 1,8 enthält,
- oder eine Schicht C, die ein Siliciumoxid umfasst und eine Dicke kleiner oder gleich 15 nm aufweist, in direktem Kontakt mit einer Schicht E, die mindestens ein Metalloxid mit einem Brechungsindex größer oder gleich 1,8 umfasst.

2. Artikel nach Anspruch 1, **dadurch gekennzeichnet, dass** es sich bei der durch eine Ionenquelle unterstützten Abscheidung um einen Ionenbeschuss handelt.

3. Artikel nach einem der vorhergehenden Ansprüche, **dadurch gekennzeichnet, dass** Verbindung A mindestens eine zweiwertige Gruppe der Formel: 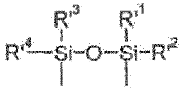 umfasst, wobei R'¹ bis R'⁴ unabhängig Alkyl-, Vinyl-, Aryl-, Hydroxylgruppen oder hydrolysierbare Gruppen bezeichnen, oder dadurch, dass Verbindung A der Formel: 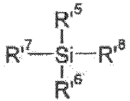 entspricht, in der R'⁵, R'⁶, R'⁷, R'⁸ unabhängig Hydroxylgruppen oder hydrolysierbare Gruppen wie OR-Gruppen bezeichnen, in denen R eine Alkylgruppe ist.

4. Artikel nach einem der vorhergehenden Ansprüche, **dadurch gekennzeichnet, dass** Verbindung A aus Octamethylcyclotetrasiloxan, Decamethyltetrasiloxan, 2, 4, 6,8-Tetramethylcyclotetrasiloxan, Hexamethyldisiloxan, Decamethylcyclopentasiloxan, Dodecamethylpentasiloxan ausgewählt ist.

5. Artikel nach einem der vorhergehenden Ansprüche, **dadurch gekennzeichnet, dass** Schicht A nicht aus anorganischen Vorläuferverbindungen gebildet ist.

6. Artikel nach einem der vorhergehenden Ansprüche, **dadurch gekennzeichnet, dass** Schicht A eine Dicke von 20 bis 500 nm aufweist.

7. Artikel nach einem der vorhergehenden Ansprüche, **dadurch gekennzeichnet, dass** er eine Schicht B aufweist, die auf Schicht A abgeschieden ist und sich in direktem Kontakt damit befindet, wobei Verbindung B mindestens eine zweiwertige Gruppe der Formel: 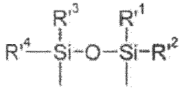 umfasst, wobei R'¹ bis R'⁴ unabhängig Alkyl-, Vinyl-, Aryl-, Hydroxylgruppen oder hydrolysierbare Gruppen bezeichnen, oder dadurch, dass Verbindung B der Formel: 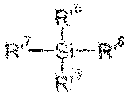 entspricht, in der R'⁵, R'⁶, R'⁷, R'⁸ unabhängig Hydroxylgruppen oder hydrolysierbare Gruppen wie OR-Gruppen bezeichnen, in denen R eine Alkylgruppe ist.

8. Artikel nach einem der vorhergehenden Ansprüche, **dadurch gekennzeichnet, dass** er eine Schicht B aufweist, die auf Schicht A abgeschieden ist und sich in direktem Kontakt damit befindet, wobei das Metalloxid mit einem Brechungsindex größer oder gleich 1,8 ein Zirconiumoxid oder ein Hafniumoxid ist.

9. Artikel nach einem der vorstehenden Ansprüche, **dadurch gekennzeichnet, dass** er die Schicht B in direktem Kontakt mit der Schicht A aufweist und eine Schicht D, die mindestens ein Metalloxid mit einem Brechungsindex größer oder gleich 1,8 umfasst, auf Schicht B und in direktem Kontakt damit abgeschieden ist, wobei Schicht D vorzugsweise unter Ionenunterstützung abgeschieden ist.

10. Artikel nach Anspruch 9, **dadurch gekennzeichnet, dass** Schicht D nicht aus organischen Vorläuferverbindungen gebildet ist.

11. Artikel nach einem der Ansprüche 1 bis 6, **dadurch gekennzeichnet, dass** er eine Schicht C aufweist, die auf Schicht A und in direktem Kontakt damit abgeschieden ist, wobei Schicht C mindestens 50 Gew.-% Silicium, bezogen auf das Gesamtgewicht der Schicht C, umfasst.

12. Artikel nach einem der Ansprüche 1 bis 6 und 11, **dadurch gekennzeichnet, dass** er eine Schicht C mit einer Dicke von 2 bis 10 nm aufweist, die auf Schicht A und in direktem Kontakt damit abgeschieden ist.

13. Artikel nach einem der vorhergehenden Ansprüche, **dadurch gekennzeichnet, dass** es sich bei der Interferenzbeschichtung um eine reflexmindernde Schicht handelt.

14. Artikel nach einem der vorhergehenden Ansprüche, **dadurch gekennzeichnet, dass** es sich dabei um eine optische Linse, vorzugsweise eine ophthalmische Linse, handelt.

15. Artikel nach einem der vorhergehenden Ansprüche, **dadurch gekennzeichnet, dass** die Interferenzbeschichtung die Schicht C in direktem Kontakt mit der Schicht E umfasst, wobei die Schicht E nicht aus organischen Vorläuferverbindungen gebildet ist.

16. Verfahren zur Herstellung eines Artikels nach einem der vorhergehenden Ansprüche, das zumindest die folgenden Schritte umfasst:
- das Bereitstellen eines Artikels, der ein Substrat mit mindestens einer Hauptfläche umfasst,
- das Abscheiden einer Schicht A, die einen Brechungsindex kleiner oder gleich 1,65 aufweist und mehr als 70 Gew.-% siliciumorganische Verbindungen A, bezogen auf die Masse der Schicht A, enthält, auf der Hauptfläche des Substrats,
- das Abscheiden auf der Schicht A:
- entweder einer Schicht B, die einen Brechungsindex größer 1,65 aufweist und mindestens ein Metalloxid mit einem Brechungsindex größer 1,8 enthält,
- oder einer Schicht C, die ein Siliciumoxid umfasst und eine Dicke kleiner oder gleich 15 nm aufweist, und das direkte Abscheiden einer Schicht E, die mindestens ein Metalloxid mit einem Brechungsindex größer oder gleich 1,8 umfasst, auf der Schicht C,
- das Erhalten eines Artikels, der ein Substrat mit einer Hauptfläche umfasst, die mit einer Interferenzbeschichtung beschichtet ist, die in der Richtung vom Substrat weg eine Schicht A in direktem Kontakt mit einer Schicht B oder eine Schicht A in direktem Kontakt mit einer Schicht C in direktem Kontakt mit einer Schicht E umfasst,
wobei die Schicht A mittels einer durch eine Ionenquelle unterstützten Vakuumabscheidung mindestens einer siliciumorganischen Verbindung A erhalten wird und die Schicht B, wenn sie vorhanden ist, mittels einer durch eine Ionenquelle unterstützten Vakuumabscheidung mindestens eines Metalloxids und mindestens einer siliciumorganischen Verbindung B erhalten wurde.

## Claims

1. An article comprising a substrate having at least one main surface coated with an interference coating comprising, in order starting from the substrate:
- a layer A obtained by vacuum deposition, assisted by a source of ions, of at least one organosilicon compound A, said layer A having a refractive index lower than or equal to 1.65 and containing more than 70 % by weight of organosilicon compounds A as compared to the weight of layer A, and, making direct contact with this layer A,
- either a layer B obtained by vacuum deposition, assisted by a source of ions, of at least one metal oxide and at least one organosilicon compound B, said layer B having a refractive index higher than 1.65 and containing at least one metal oxide having a refractive index higher than or equal to 1.8,
- or a layer C comprising a silicon oxide and having a thickness lower than or equal to 15 nm, making direct contact with a layer E comprising at least one metal oxide having a refractive index higher than or equal to 1.8.

2. The article as claimed in claim 1, **characterized in that** the deposition assisted by a source of ions is an ion bombardment.

3. The article as claimed in any one of the preceding claims, **characterized in that** the compound A comprises at least one divalent group of formula: 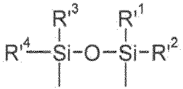 where R'¹ to R'⁴ independently denote alkyl, vinyl, aryl or hydroxyl groups or hydrolysable groups, or **in that** the compound A corresponds to the formula: 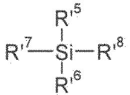 in which R'⁵, R'⁶, R'⁷ and R'⁸ independently denote hydroxyl groups or hydrolysable groups, such as OR groups, in which R is an alkyl group.

4. The article as claimed in any one of the preceding claims, **characterized in that** the compound A is chosen from octamethylcyclotetrasiloxane, decamethyltetrasiloxane, 2,4,6,8-tetramethylcyclotetrasiloxane, hexamethyldisiloxane, decamethylcyclopentasiloxane and dodecamethylpentasiloxane.

5. The article as claimed in any one of the preceding claims, **characterized in that** said layer A is not formed from inorganic precursor compounds.

6. The article as claimed in any one of the preceding claims, **characterized in that** the layer A has a thickness ranging from 20 to 500 nm.

7. The article as claimed in any one of the preceding claims, **characterized in that** it possesses a layer B deposited on the layer A and in direct contact therewith, the compound B of which includes at least one divalent group of formula: 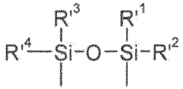 where R'¹ to R'⁴ independently denote alkyl, vinyl, aryl or hydroxyl groups or hydrolysable groups, or **in that** the compound B corresponds to the formula: 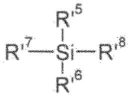 in which R'⁵, R'⁶, R'⁷ and R'⁸ independently denote hydroxyl groups or hydrolysable groups, such as OR groups, in which R is an alkyl group.

8. The article as claimed in any one of the preceding claims, **characterized in that** it possesses a layer B deposited on the layer A and in direct contact therewith, the metal oxide having a refractive index higher than or equal to 1.8 of which is a zirconium oxide or a hafnium oxide.

9. The article as claimed in any one of the preceding claims, **characterized in that** it possesses said layer B making direct contact with said layer A, and a layer D comprising at least one metal oxide having a refractive index higher than or equal to 1.8 deposited on the layer B and in direct contact therewith, the layer D preferably being deposited under ion assistance.

10. The article as claimed in claim 9, **characterized in that** said layer D is not formed from organic precursor compounds.

11. The article as claimed in any one of claims 1 to 6, **characterized in that** it possesses a layer C deposited on the layer A and in direct contact therewith, the layer C containing at least 50 wt% silica relative to the total weight of the layer C.

12. The article as claimed in any one of claims 1 to 6 and 11, **characterized in that** it possesses a layer C having a thickness ranging from 2 to 10 nm deposited on the layer A and in direct contact therewith.

13. The article as claimed in any one of the preceding claims, **characterized in that** the interference coating is an antireflection coating.

14. The article as claimed in any one of the preceding claims, **characterized in that** it is an optical lens, preferably an ophthalmic lens.

15. The article as claimed in any one of the preceding claims, **characterized in that** the interference coating comprises said layer C in direct contact with said layer E, said layer E not being formed from organic precursor compounds.

16. A process for the manufacture of an article as claimed in any one of the preceding claims, comprising at least the following steps:
- supplying an article comprising a substrate having at least one main surface,
- depositing, on said main surface of the substrate a layer A having a refractive index lower than or equal to 1.65 and containing more than 70 % by weight of organosilicon compounds A as compared to the weight of layer A,
- depositing on said layer A:
- either a layer B having a refractive index higher than 1.65 and containing at least one metal oxide having a refractive index higher than 1.8,
- or a layer C comprising a silicon oxide and having a thickness lower than or equal to 15 nm, and depositing directly on said layer C a layer E comprising at least one metal oxide having a refractive index higher than or equal to 1.8,
- collecting an article comprising a substrate having a main surface coated with an interference coating comprising, in order starting from the substrate, a layer A making direct contact with a layer B or a layer A making direct contact with a layer C making direct contact with a layer E, said layer A having been obtained by vacuum deposition, assisted by a source of ions, of at least one organosilicon compound A, and said layer B, when it is present, having been obtained by vacuum deposition, assisted by a source of ions, and at least one metal oxide and at least one organosilicon compound B.
